# EUROPEAN PATENT APPLICATION

(11) **EP 1 635 455 A1**
(43) Date of publication of application: **15.03.2006**
(21) Application number: 05018935.6
(22) Date of filing: 31.08.2005
(51) Int. Cl.: H03G 3/34

(54) **Mute circuit**

(30) Priority: 09.09.2004 JP 2004263100
(71) Applicant: ORION ELECTRIC CO., Ltd., Takefu-City, Fukui 915-8555 (JP)
(72) Inventor: Tsubokawa, Yukio, Takefu-city, Fukui 915 8555 (JP)
(74) Representative: Goddar, Heinz J.

(57) **Abstract**

The invention is to provide a mute circuit (30) capable of surely muting various noises generated in a signal output line (L, R) with a simple circuit configuration and a signal output device (2) provided with the same. A resistor (R1, R2) and a capacitor (C1, C2) are serially connected to each other on the signal output line (L, R) of an analog signal outputted from a D/A converter (40), and a predetermined voltage (Vc) is impressed thereon. The voltage (Vc) is set to a level which is higher than a reference voltage (V0) to be supplied to the signal output line (L, R). In cases where noises are generated on the signal output line (L, R) owing to variation of a voltage having an inverted polarity relative to the reference voltage (V0), the variation is offset by the discharge of the capacitor (C1, C2) while in cases where the noises are generated owing to the variation of a voltage having the same polarity, a resistance of the resistor (R1, R2) is set to absorb the voltage variation.

## Description

### FIELD OF THE INVENTION

The invention relates to a mute circuit for use in an video picture output device such as a CRT, a liquid display unit and so forth, and an audio output device such as speakers and so forth, and a signal output device using the same.

### RELATED ART

In the conventional signal output device, there occurs a problem that noises are generated when channels are switched over, for example, in cases where a power supply is turned ON or OFF, thereby generating an impulse audio, a so-called pop sound in an audio output unit, or disturbing video picture in an video picture output device. There has been developed a technique to avoid an output caused by such noises.

For example, JP 6-325370A discloses a mute circuit provided with an optical disk reproducer having a CPU for outputting a mute signal having a predetermined pulse width and a switching transistor for dropping an audio signal output of an audio circuit to a ground level. Further, JP 2003-179435A discloses a mute circuit for grounding an input terminal of a power amplifier by a control signal. Still further, JP 11-163648A discloses that an emitter is grounded while a collector is connected to an audio output line, and a pop noise, which is generated on an audio output line during a time interval when a mute pulse is inputted to a base thereof, is muted.

The inventions disclosed in the foregoing references are structured such that the transistor for grounding the signal output line is provided to lower the signal output line to a ground potential level so that noises to be generated on the signal output line are not transmitted to an output device such as speakers and so forth. However, there required circuit elements such as transistors and so forth so as to lower the signal output line to a ground potential, and the circuit has to be devised in timing control for lowering the signal output line to the ground potential in response to noise generating timing, resulting in a complex circuit configuration.

It is necessary to treat digital signals in various formats as signals for use in an video picture output and an audio output are digitalized, and when such signals are digitalized in different formats and subjected to D/A conversion, noises are frequently generated. Accordingly, a mute processing has to be implemented for conceivable various cases of generation of noises, which increases much developing cost.

### SUMMERY OF THE INVENTION

It is therefore an object of the invention to provide a mute circuit capable of surely muting various noises generated on a signal output line with a simple circuit configuration, and a signal output device provided with the same.

The mute circuit of the invention comprises a voltage impressing circuit connected to a signal output line, on which an analog signal inputted to the output device is transmitted, via a resistor and a capacitor wherein a voltage having substantially the same as a reference voltage of the signal output line is impressed on the signal output line by a predetermined voltage to be impressed by the voltage impressing circuit.

The signal output device of the invention is provided with the mute circuit.

With the circuit configuration set forth above, it is possible to mute the signal output line with a simple circuit configuration comprised of the resistor, the capacitor, and the voltage impressing circuit. That is, the voltage impressing circuit can serve as a voltage impressing circuit provided in the signal output device, and it is possible to set the mute circuit such that if characteristics of the resistor and the capacitor are appropriately adjusted, a voltage having substantially the same as the reference voltage of the signal output line can be impressed on the signal output line. If there occur noises caused by an abrupt voltage variation on the signal output line, a voltage for suppressing such voltage variation owing to the operations of the capacitor and the resistor is automatically generated, thereby preventing the noises from being inputted to the output device. Inasmuch as the mute circuit operates automatically coping with such abrupt voltage variation, a microcomputer control and so forth in conformity with a generating timing of each noise are not needed. Further, since a voltage having substantially the same as the reference voltage of the signal output line is set to be impressed on the output signal line by a predetermined voltage which is impressed by the voltage impressing circuit, there doesn't occur any problem even if the circuit is always in an impressing state. Further, the characteristics of the capacitor and the resistor and the voltage value to be impressed are adjusted in advance relative to a magnitude of the voltage variation of the noises or cycle of the noises, it is possible to surely mute various noises.

### BRIEF DESCRIPTION OF THE DRAWINGS

Fig. 1 is a block diagram showing an entire circuit configuration according to an embodiment of the invention;
Fig. 2 is a circuit configuration showing the mute circuit; and
Fig. 3A and 3B show noise waveforms, respectively.

### PREFERRED EMBODIMENT OF THE INVENTION

An embodiment of the invention will be described in detail hereinafter. As the embodiment described hereinafter represents a preferred specific example in carrying out the invention, it is to be understood that the invention is not limited thereto unless otherwise explicitly described hereinafter although various technical limitations are made in the invention.

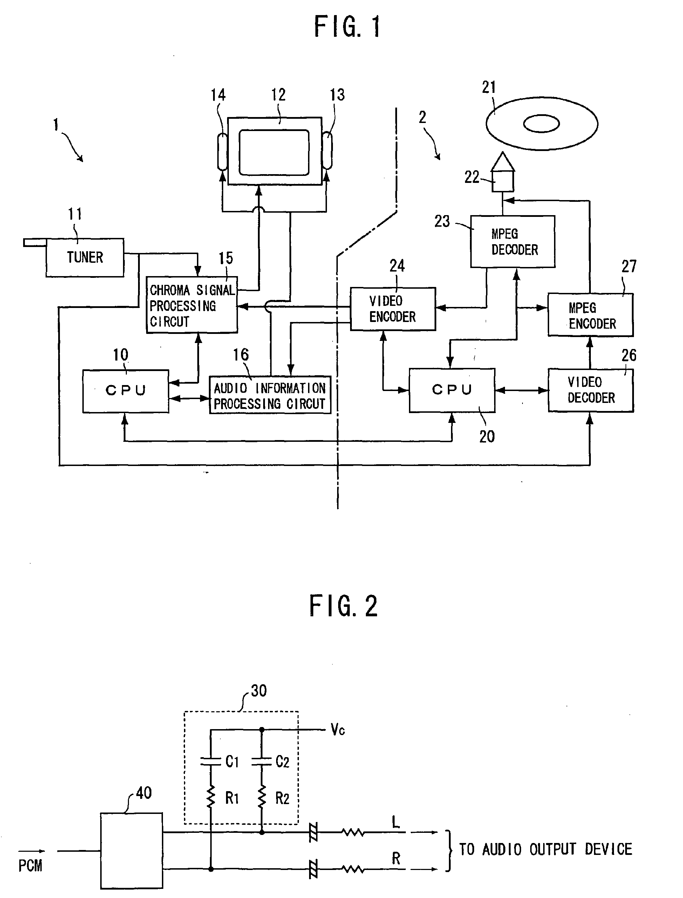

Fig. 1 is an entire circuit configuration of a TV receiver 1 provided with a DVD reproducer 2, as an example of a signal output device of the invention. The TV receiver 1 comprises a CPU 10 for implementing information processing regarding entire control of the TV receiver 1, a tuner 11 for receiving a TV signal from an outside, a monitor 12 for displaying video picture, right and left speakers 13, 14 built in the monitor 12. An output signal from the tuner 11 is processed in a chroma signal processing circuit 15 wherein video picture information is transmitted to the monitor 12 serving as a video picture output device to be subjected to display control while audio information is transmitted to an audio information processing circuit 16 by the control of the CPU 10, and audio-outputted from the right and left speakers 13, 14, serving as an audio output device.

Meanwhile, the TV receiver 1 is provided with the DVD reproducer 2 having a CPU 20 for use in a DVD which implements information processing regarding reproducing control. Information recorded by a pickup 22 in a disk 21 which is rotated by a rotary control device, not shown, is read out, and is decoded by an MPEG decoder 23. Since decoded information is digital information, it is analogized by a video encoder 24 and transmitted to the chroma signal processing circuit 15 and the audio information processing circuit 16, subsequently video picture is displayed on the monitor 12, and at the same time audio is audio-outputted by the right and left speakers 13, 14.

Further, it is possible that the analog signal received by the tuner 11 is converted into the digital signal after connecting a video decoder 26 of the DVD reproducer 2 side to the tuner 11, then the digital signal is compressed by an MPEG encoder 27, thereafter the compressed digital signal is subjected to record processing on the disk 21 by a pickup 22.

With the signal output device having the foregoing circuit configuration, there occurs a case where noises ride on the signal output line from the chroma signal processing circuit 15 or on the signal output line from the audio information processing circuit 16 at the time of ON/OFF of the power supply when channels are switched over or a case where noises are generated in a D/A converter circuit of the video encoder 24 when formats of the digital signal recorded in the DVD are switched over. Such noises generate an impulse sound which is a so-called pop sound and difficult to be heard if it is outputted from the speakers. Further, if such impulse noise is displayed on the monitor, video picture is disturbed to be difficult to be watched.

Fig. 2 shows a mute circuit 30 for eliminating such noises. In Fig. 2, a digital signal PCM is received by a D/A converter 40 where it is converted into an analog signal, and outputted as stereo audio signals L or R so as to be inputted to the audio output device. The mute circuit 30 is connected to each signal output line of audio signals L and R, and a capacitor C1 and a resistor R1 are serially connected to each other on the signal output line of the audio signal R while a capacitor C2 and a resistor R2 are serially connected to each other on the signal output line of the audio signal L. The capacitors C1 and C2 are connected to a constant voltage circuit, not shown, on which a predetermined voltage Vc is impressed. As the constant voltage circuit, a constant voltage circuit of a power supply for supplying a voltage to the tuner 11 and the audio information processing circuit 16 may be doubled. The voltage Vc is higher than a reference voltage V0 which is supplied from the D/A converter 40 to the signal output lines. The voltage Vc to be impressed is lowered to become substantially the same as the reference voltage V0 by adjusting the characteristics of the capacitor and the resistor, to be impressed on the signal output lines.

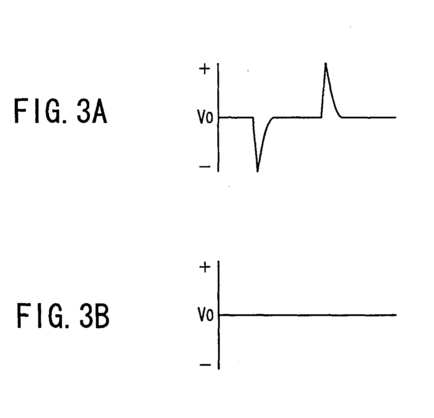

Fig. 3A shows a noise waveform in the case of non-connection with the mute circuit 30 while Fig. 3B shows a noise waveform in the case of connection with the mute circuit 30. The noise is generally generated as an abrupt voltage variation at the plus or minus side. In this example, provided that the reference voltage V0 supplied from the D/A converter 40 to the signal output lines serve as a reference, the minus side means a case where the voltage is smaller than the reference voltage V0 and the plus side means a case where the voltage is larger than the reference voltage V0. The abrupt voltage variation of the noise is first generated at the minus side, then at the plus side.

When the noise is generated at the minus side, the voltage is varied largely toward the minus side, and hence the capacitor C1 is discharged to operate to offset the voltage by the variation of the voltage toward the minus side, resulting in elimination of the noise at the minus side as shown in Fig. 3B. On the other hand, when the noise is generated at the plus side, although the voltage is varied largely toward the plus side, provided that the resistance value of the resistor R1 is set in such a way that the voltage level at the output line side of the resistor Rlis equal to or larger than the level of the noise at the plus side, the noise is absorbed, resulting in also elimination of the noise at the plus side.

In such a way, the noise at the minus side and the plus side can be automatically eliminated in correspondence with the generation of the noise at the minus and plus sides, thereby surely muting various noises without requiring the control, e.g. such as a microcomputer control for generating a mute pulse. Further, since there is no affection relative to the signal output line (the resistor R1 has only to be set to a high resistance so that the frequency characteristics of the capacitor C1 does not affect the signal output line) even in a state where the constant voltage Vc is always impressed, the mute circuit can be turned on at the same time of turning on the power supply.

As an example, provided that the reference voltage V0 of the signal output line is set to 2.5V, the constant voltage Vc to be impressed is set at 12V, a resistance of the resistor R1 is set to 5.6kΩ, a capacitance of the capacitor C1 is set to 0.1*µ*F, it was confirmed that substantially the entire noises to be generated on the signal output lines could be eliminated.

The mute circuit described above can be connected to the signal output lines through which the analog signal to be inputted to the output device is transmitted, and it is effective relative to a control signal such as a bright signal in addition to the video picture signal and the audio signal.

## Claims

1. A mute circuit (30) comprising:
a voltage impressing circuit connected to a signal output line (L, R), on which an analog signal inputted to an output device (12; 13, 14) is transmitted, via a resistor (R1, R2) and a capacitor (C1, C2);
wherein a voltage having substantially the same as a reference voltage (V0) of the signal output line (L, R) is impressed on the signal output line (L, R) by a predetermined voltage to be impressed by the voltage impressing circuit.

2. A signal output device (2) provided with the mute circuit (30) according to Claim 1.
